# EUROPÄISCHE PATENTSCHRIFT

(11) **EP 3 630 525 B1**
(45) Veröffentlichungstag und Bekanntmachung des Hinweises auf die Patenterteilung: **06.07.2022**
(21) Anmeldenummer: 18719145.7
(22) Anmeldetag: 19.04.2018
(51) Int. Cl.: B60T 8/88, B60L 3/00, B60L 3/10, B60T 8/171, B60T 8/32, B60T 17/22, G01P 3/44, H02J 9/00, H02J 9/06, G01P 13/04, G01P 3/488, G01P 21/00

(54) **VERFAHREN ZUM BETREIBEN EINES DREHZAHLSENSORS IN EINEM FAHRZEUG, SOWIE SENSORANORDUNG**
METHOD FOR OPERATING A ROTATIONAL SPEED SENSOR IN A VEHICLE, AND SENSOR ASSEMBLY
PROCÉDÉ POUR FAIRE FONCTIONNER UN CAPTEUR DE VITESSE DANS UN VÉHICULE, ET AGENCEMENT DE CAPTEUR

(30) Priorität: 27.05.2017 DE 102017005071
(43) Veröffentlichungstag der Anmeldung: 08.04.2020
(73) Patentinhaber: ZF CV Systems Europe BV, 1170 Brussels (BE)
(72) Erfinder: GOERS, Andreas, 30982 Pattensen (DE); VAN THIEL, Julian, 30938 Grossburgwedel (DE); WULF, Oliver, 31535 Neustadt (DE)
(74) Vertreter: Rabe, Dirk-Heinrich
(86) Internationale Anmeldenummer: PCT/EP2018/060061
(87) Internationale Veröffentlichungsnummer: WO 2018/219553

(56) Entgegenhaltungen:
- EP-A2- 1 478 072
- DE-A1-102005 013 028
- DE-A1-102010 037 262
- DE-A1-102012 212 272
- DE-A1-102015 209 565
- US-A1- 2008 174 181
- SHI F ET AL: "Integrated power systems with fault tolerant attributes", APPLIED POWER ELECTRONICS CONFERENCE AND EXPOSITION, 1997. APEC '97 CO NFERENCE PROCEEDINGS 1997., TWELFTH ANNUAL ATLANTA, GA, USA 23-27 FEB. 1, NEW YORK, NY, USA,IEEE, US, Bd. 1, 23. Februar 1997 (1997-02-23), Seiten 443-447, XP010215855, DOI: 10.1109/APEC.1997.581490 ISBN: 978-0-7803-3704-6

## Beschreibung

Die Erfindung betrifft ein Verfahren zum Betreiben eines Drehzahlsensors in einem Fahrzeug, insbesondere Nutzfahrzeug, sowie eine Sensoranordnung mit mindestens einem Drehzahlsensor zur Durchführung des Verfahrens.

Drehzahlsensoren in einem Fahrzeug, insbesondere einem Nutzfahrzeug, dienen dazu, das Drehverhalten eines Rades zu erfassen und die dazu ermittelten Drehzahlen für eine Fahrdynamik-Regelung, beispielsweise eine Antiblockier-Regelung (ABS-Regelung) oder eine Antriebsschlupf-Regelung (ARS-Regelung), zu verwenden. Dadurch können Instabilitäten im Fahrzeug vermieden werden, wenn beispielsweise an jedem Rad des Fahrzeuges eine derartige Überwachung der Drehzahlen stattfinden kann und entsprechend dem Überwachungsergebnis bremsend an einzelnen Rädern eingegriffen wird.

Ein derartiger Drehzahlsensor kann induktiv oder aktiv betrieben werden. Ein induktiver Drehzahlsensor weist hierbei als Sensorelement beispielsweise eine Spulenwicklung auf und ein aktiver Drehzahlsensor als Sensorelement beispielsweise einen Hall-Sensor. Ein mit dem Rad mitdrehendes Polrad mit Pol-Zähnen und Pol-Lücken induziert bzw. erzeugt im jeweiligen Sensorelement je nach Abstand eine unterschiedliche Wirkspannung bzw. einen veränderlichen Wirkstrom, die jeweils von einem Auswertemodul des Drehzahlsensors verarbeitet und in entsprechender Form ausgegeben werden können, um daraus über eine Kalibrierung die Drehzahl des Rades ermitteln zu können.

Hierbei wird vom Auswertemodul in Abhängigkeit von der in dem jeweiligen Sensorelement erzeugten Wirkgröße zum einen eine analoge Messgröße, z.B. eine Messspannung, und zum anderen eine Komparator-Spannung ausgegeben. Die analoge Messspannung ist im Wesentlichen proportional zur in dem Sensorelement erzeugten Wirkgröße und die Komparator-Spannung wird in Form einer Rechteckspannung ausgegeben, die angibt, ob die Messspannung nach oben oder unten um einen bestimmten Schwellwert abweicht, d.h. ob durch eine ggf. vorliegende Bewegung des Polrades eine gewisse Messspannung erzeugt wird. Liegt eine Abweichung um mehr als den Schwellwert vor, wird ein Spannungspuls erzeugt und über die Komparator-Spannung ausgegeben. Aus der Rechteckspannung kann somit auf die Drehzahl des Rades geschlossen werden, wenn die Anzahl der Pol-Zähne des Polrades bekannt ist. Eine derartige Funktionsweise ist beispielhaft in EP 0 883 536 B1 gezeigt. Ein weiterer Sensor aus dem Stand der Technik ist in der DE 10 2015 209565 A1 dargestellt.

Mit der analogen Messspannung kann beispielsweise eine Plausibilisierung bzw. Überwachung der Funktion des Drehzahlsensors erfolgen, indem beispielsweise geprüft wird, ob eine Amplitude oder ein Spannungswert der analogen Messspannung mit der Höhe der aus der Komparator-Spannung ermittelten Drehzahl zumindest tendenziell übereinstimmt.

Die Energieversorgung der Drehzahlsensoren im Fahrzeug erfolgt herkömmlicherweise von dem Auswertemodul aus, das beispielsweise an eine Energiequelle des Fahrzeuges, beispielsweise an eine Fahrzeugbatterie oder an eine Lichtmaschine angeschlossen ist, und eine für die Messung und Auswertung benötigte Sensor-Spannung insbesondere zur Versorgung des jeweiligen Sensorelementes bereitstellt.

Um mit derartigen Drehzahlsensoren in einem ggf. rein elektronisch gesteuerten Bremssystem (EBS) eine sichere und zuverlässige ABS- oder ASR-Regelung zu gewährleisten, ist eine elektrische Funktionsfähigkeit aller Drehzahlsensoren sicherzustellen. Dazu findet beispielsweise die Plausibilisierung der beiden Spannungen bzw. Signale wie bereits erwähnt statt.

Wurde ein Ausfall oder eine Fehlfunktion erkannt, kann im Rahmen der jeweiligen Fahrdynamikregelung allerdings nicht mehr sichergestellt werden, dass adäquat auf eine bestimmte Instabilität reagiert werden kann. Um dies zu vermeiden, kann an jedem Rad ein redundanter Drehzahlsensor mit redundanter Energiequelle und redundantem Auswertemodul vorgesehen sein, so dass bei einem Erkennen eines Ausfalls oder einer Funktionsstörung der oder die jeweils ausgefallenen Drehzahlsensoren ersetzt werden können und somit weiterhin auf die Raddrehzahlen zurückgegriffen werden kann. Nachteilig hierbei ist, dass eine derartige Redundanz sehr teuer ist und zudem sehr viel Platz an den Rädern bzw. den Achsen des Fahrzeuges in Anspruch nimmt. Zudem ist bei einem Ausfall lediglich der Energieversorgung des jeweiligen Drehzahlsensors bzw. des Auswertemoduls ein Rückgriff auf einen anderen Drehzahlsensor nicht zwingend nötig.

Es ist daher Aufgabe der Erfindung, ein Verfahren zum Betreiben eines Drehzahlsensors in einem Fahrzeug anzugeben, mit dem in einfacher und zuverlässiger Weise auch bei einer Funktionsstörung eine Drehzahl eines Rades erfasst werden kann. Weiterhin ist Aufgabe der Erfindung, eine Sensoranordnung zur Durchführung des Verfahrens bereitzustellen.

Diese Aufgabe wird durch ein Verfahren nach Anspruch 1 gelöst. In den Unteransprüchen sind bevorzugte Weiterbildungen angegeben.

Erfindungsgemäß ist demnach vorgesehen, die Funktionsfähigkeit eines Auswertemoduls dahingehend zu überwachen, ob ein Sensorelement eines Drehzahlsensors von dem Auswertemodul mit einer Sensor-Spannung versorgt wird oder werden kann. Bei einer Funktionsstörung des Auswertemoduls, infolge derer das Sensorelement nicht mehr von dem Auswertemodul mit der Sensors-Spannung versorgt wird oder werden kann und demnach eine zuverlässige Auswertung des Drehverhalten des Rades nicht mehr sichergestellt werden kann, wird eine Redundanz-Sensor-Spannung von einem von dem Auswertemodul unabhängigen Redundanzmodul bereitgestellt, mit der das Sensorelement stattdessen versorgt wird.

Erfindungsgemäß wird somit bereits erkannt, dass in einer Sensoranordnung mit einem oder mehreren Drehzahlsensoren, deren Sensorelemente im Normalbetrieb jeweils von dem Auswertemodul aus mit einer Sensor-Spannung versorgt werden, bei einer Funktionsstörung des Auswertemoduls nicht auf redundante Sensorelemente zurückzugreifen ist oder der Betrieb des Drehzahlsensors einzustellen ist, sondern stattdessen eine unabhängige redundante Spannungsversorgung der Sensorelemente erfolgen kann, so dass der Betrieb des Drehzahlsensors redundant fortgesetzt werden kann. Demnach können Kosten und Platz gespart werden und das Drehverhalten des Rades kann weiterhin beispielsweise für eine Fahrassistenz-Regelung, beispielsweise eine Bremsschlupfregelung und/oder eine Antriebsschlupfregelung, herangezogen werden.

Vorzugsweise ist weiterhin vorgesehen, dass bei einer Funktionsstörung des Auswertemoduls, infolge derer das Sensorelement nicht mehr von dem Auswertemodul mit der Sensors-Spannung versorgt wird oder werden kann, eine durch eine Wechselwirkung eines mit dem Rad verbundenen Polrades mit dem Sensorelement erzeugte Wirkgröße, beispielsweise eine induzierte Wirkspannung oder ein beeinflusster Wirkstrom, in Form einer Redundanz-Messgröße in dem Redundanzmodul ausgewertet wird. In Abhängigkeit der Redundanz-Messgröße kann von dem Redundanzmodul eine die Drehzahl des Rades charakterisierende Redundanz-Ausgangsgröße ausgegeben werden.

Vorteilhafterweise kann dadurch eine redundante Auswertung gewährleistet werden, da das Redundanzmodul unabhängig von dem Auswertemodul die aufgenommenen Messgrößen auch auswerten und entsprechend verarbeitet ausgeben kann. Das Redundanzmodul übernimmt somit bei einer Funktionsstörung automatisch die volle Funktion des Auswertemoduls, da nach Feststellen der Funktionsstörung zu erwarten ist, dass nicht nur die Versorgung der Sensorelemente mit der Sensor-Spannung ausgefallen ist, sondern ebenfalls auch eine Verarbeitung der ermittelten Messgrößen nicht mehr erfolgen kann.

Vorzugsweise kann die Redundanz-Sensor-Spannung bei Erkennen einer Funktionsstörung derartig vom Redundanzmodul bereitgestellt werden, dass Redundanz-Versorgungspunkte des Redundanzmoduls derartig über Redundanz-Leitungen mit dem Sensorelement elektrisch leitend verbunden werden, dass das Sensorelement mit der über die Redundanz-Versorgungspunkte bereitgestellten Redundanz-Sensor-Spannung versorgt werden kann. Liegt keine Funktionsstörung vor, sind die Redundanz-Versorgungspunkte hingegen elektrisch von dem Sensorelement getrennt.

Dadurch wird vorteilhafterweise sichergestellt, dass die unabhängig von der Sensor-Spannung bereitgestellte Redundanz-Sensor-Spannung lediglich im Bedarfsfall an die Sensorelemente angelegt wird, so dass die Auswertung im Normalbetrieb, d.h. ohne eine Funktionsstörung, nicht maßgeblich durch den Betrieb des Redundanzmoduls beeinflusst wird.

Zum Verbinden und Trennen der Redundanz-Versorgungspunkte mit bzw. von dem Sensorelement im Bedarfsfall sind vorzugsweise elektrische Schalter vorgesehen, die in Abhängigkeit der Funktionsfähigkeit des Auswertemoduls elektrisch gesteuert geöffnet oder geschlossen werden können. Damit wird eine einfache Möglichkeit angegeben, den redundanten Eingriff zu ermöglichen, wobei die Steuerung der elektrischen Schalter beispielsweise durch ein die Überwachung der Funktion des Auswertemoduls durchführendes Redundanz-Überwachungsmodul im Redundanzmodul erfolgt.

Zur Überwachung ist hierbei gemäß einer Variante vorgesehen, dass das Redundanzmodul ein von dem Auswertemodul ausgegebenes Diagnose-Signal überwacht, wobei das Diagnose-Signal angibt, ob das Sensorelement über das Auswertemodul mit der Sensor-Spannung versorgt wird oder werden kann. Das Diagnose-Signal kann hierbei in einer Selbstdiagnose im Auswertemodul ermittelt und ständig an das Redundanzmodul übertragen werden. Dadurch ist eine einfache Möglichkeit der Überwachung gegeben, infolge derer entschieden wird, ob das Redundanzmodul entsprechend redundant einzugreifen hat.

Erfindungsgemäß ist vorgesehen, dass zur Überwachung der Funktionsfähigkeit des Auswertemoduls weitere Sensorelemente einer Sensoranordnung einbezogen werden. Dazu werden im Redundanzmodul mindestens die folgenden Schritte durchgeführt:
Zunächst wird eine sich in dem Redundanzmodul einstellenden Redundanz-Messgröße erfasst , wobei sich die Redundanz-Messgröße aufgrund der Wechselwirkung des Polrades mit dem Sensorelement, das mit einer gewissen Sensor-Spannung versorgt wird, ergibt. Nachfolgend rd ermittelt, ob diese Redundanz-Messgröße darauf hinweist, dass das Sensorelement mit einer Sensor-Spannung versorgt wird, die innerhalb einer Fehlertoleranz einem Massepotential entspricht.

Somit kann zunächst in einfacher Weise erkannt werden, ob für zumindest ein Sensormodul im Redundanzmodul eine Redundanz-Messgröße erfasst wird, die auf eine fehlende Spannungsversorgung des betreffenden Sensorelementes über das Auswertemodul hinweist. Um nun zu unterscheiden, ob dies durch einen Sensordefekt verursacht wird oder dadurch, dass vom Auswertemodul keine Sensor-Spannung mehr bereitgestellt wird, ist außerdem vorgesehen, für weitere Sensorelemente von weiteren Drehzahlsensoren derselben Sensoranordnung, die ebenfalls von demselben Auswertemodul mit der Sensor-Spannung versorgt werden und die ebenfalls von dem Redundanzmodul auf eine Funktionsstörung überwacht werden, zu prüfen, ob die den weiteren Sensorelementen zugeordneten Redundanz-Messgrößen ebenfalls auf eine Sensor-Spannung hinweisen, die innerhalb der Fehlertoleranz einem Massepotential entspricht. Erst wenn dies der Fall ist, wird auf eine Funktionsstörung des Auswertemoduls geschlossen, infolge derer das Sensorelement nicht mehr von dem Auswertemodul mit der Sensor-Spannung versorgt wird oder werden kann.

Somit wird durch Rückgriff auf weitere Sensorelemente ermittelt, ob auch an diesen die Spannungsversorgung fehlt bzw. beeinträchtigt ist und daraus auf eine entsprechende Funktionsstörung des Auswertemoduls geschlossen, infolge derer das Redundanzmodul versorgend und auch auswertend redundant eingreift.

Vorzugsweise kann hierbei bei einem erkannten Stillstand des Rades zusätzlich ermittelt werden, ob die Redundanz-Messgröße einer Mittenspannung und/oder einem Mittenstrom entspricht, die sich im Stillstand des Rades aufgrund der Versorgung des Sensorelementes mit der Sensor-Spannung ohne eine Wechselwirkung des Sensorelementes mit dem Polrad einstellt. Somit kann vorteilhafterweise auch im Stillstand des Rades eine Auswertung im Hinblick darauf erfolgen, ob durch das Vorliegen der Sensor-Spannung eine entsprechende Messgröße bzw. Redundanz-Messgröße erzeugt wird, die ohne das Vorliegen der Sensor-Spannung wegfällt.

Weiterhin kann die Redundanz-Messgröße nach dem Erfassen auch zunächst plausibilisiert werden, wobei dazu aus der Redundanz-Messgröße in einem Redundanz-Komparatormodul des Redundanzmoduls als Ausgangsgröße eine Redundanz-Komparator-Spannung oder ein Redundanz-Komparator-Signal erzeugt werden, die angeben, ob die Redundanz-Messgröße infolge einer Wechselwirkung des Sensorelementes mit einem Pol-Zahn des Polrades um mehr als einen Schwellwert von der Mittenspannung oder dem Mittenstrom abweicht. Aus einem Vergleich der Redundanz-Messgröße mit der Redundanz-Komparator-Spannung oder dem Redundanz-Komparator-Signal kann auf Inkonsistenzen in der erfassten Redundanz-Messgröße und somit der darauf basierenden Drehzahl geschlossen werden. Demnach kann die Überwachung beispielsweise auch bereits abgebrochen werden, wenn eine nicht plausible bzw. sinnvolle Drehzahl aus der Redundanz-Messgröße oder der Redundanz-Komparator-Spannung/Signal folgt.

Somit befindet sich das Redundanzmodul im Rahmen der Überwachung im Normalbetrieb zunächst in einem passiven Betriebsmodus, in dem die Wirkgröße des jeweiligen Sensorelementes über die jeweilige Redundanz-Messgröße lediglich "beobachtet" wird und eine Versorgung des jeweiligen Sensorelementes nicht über das Redundanzmodul stattfindet. Das Auswertemodul hingegen befindet sich in einem aktiven Betriebsmodus, in dem sowohl eine Beobachtung der jeweiligen Wirkgröße über die jeweilige Messspannung sowie auch eine Versorgung des jeweiligen Sensorelementes über die Sensor-Spannung stattfindet. Wurde eine Funktionsstörung nach den obigen Ausführungen erkannt, wird das Redundanzmodul aktiv und das Auswertemodul passiv.

Die jeweiligen Messgrößen bzw. Redundanz-Messgrößen können hierbei je nach Art des Sensorelementes in Form einer Spannung oder eines Stromes vorliegen. Ist beispielsweise ein induktives Sensorelement vorgesehen, wird als Wirkgröße eine induzierte Wirkspannung vorgegeben, die der Mittenspannung überlagert als Messspannung im Auswertemodul bzw. als Redundanz-Messspannung im Redundanzmodul verarbeitet wird. Im Falle eines aktiven Sensorelementes, beispielsweise eines Hall-Sensorelementes, wird als Wirkgröße ein Wirkstrom vorgegeben, der dem Mittenstrom überlagert als Messstrom bzw. Redundanz-Messstrom in dem Auswertmodul bzw. dem Redundanz-Modul verarbeitet wird.

Die Erfindung wird im Folgenden anhand der beiliegenden Zeichnungen näher erläutert. Es zeigen:
- Fig. 1a: eine schematische Ansicht eines einem Rad eines Fahrzeuges zugeordneten induktiven Drehzahlsensors;
- Fig. 1b: ein beispielhafter Verlauf einer von dem induktiven Drehzahlsensor gemäß Fig. 1a erzeugten Messspannung bei Drehung des Rades;
- Fig. 2a, 2b: schematische Ansichten einer induktiven Sensoranordnung mit zwei induktiven Drehzahlsensoren nach Fig. 1a in einem Normalbetrieb sowie bei einer Funktionsstörung;
- Fig. 3a: eine schematische Ansicht einer aktiven Sensoranordnung mit zwei aktiven Drehzahlsensoren in einem Normalbetrieb;
- Fig. 3b: ein beispielhafter Verlauf einer von dem aktiven Drehzahlsensor gemäß Fig. 3a erzeugten Messstrom bei Drehung des Rades; und
- Fig. 4: ein Flussdiagramm des erfindungsgemäßen Verfahrens.

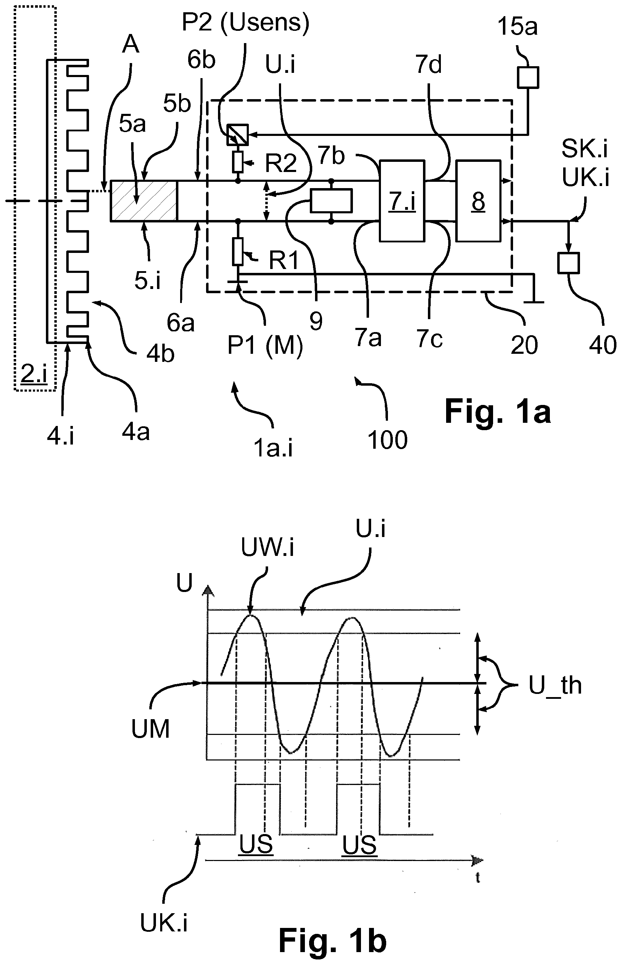

Die Fig. 1a zeigt einen induktiven Drehzahlsensor 1a.i, der einem bestimmten Rad 2.i eines Fahrzeuges 100 zugeordnet ist und der dazu vorgesehen ist, eine Ausgangsgröße SK.i, UK.i auszugeben, die die Drehzahl D.i des Rades 2.i charakterisiert. Mit dem Index i wird angegeben, dass im Fahrzeug 100 an weiteren Rädern 2.i weitere induktive Drehzahlsensoren 1a.i vorhanden sein können, die in identischer Weise wie im Folgenden beschrieben betrieben werden:
Vorgesehen ist demnach ein mit dem jeweiligen Rad 2.i mitdrehendes magnetisches, beispielsweise ferromagnetisches, Polrad 4.i mit Pol-Zähnen 4a und Pol-Lücken 4b, das sich beabstandet zu einem induktiven Sensorelement 5.i des jeweiligen Drehzahlsensors 1a.i bewegt und sich demnach je nach Verdrehung in unterschiedlichen Abständen A zum induktiven Sensorelement 5.i befindet.

Das induktive Sensorelement 5.i weist einen magnetischen Kern 5a und eine den Kern 5a zumindest teilweise umgebende Spulenwicklung 5b auf, die mit zwei Sensor-Leitungen 6a, 6b verbunden ist, so dass ein induktives Bauelement ausgebildet wird, in das je nach Abstand A zum ferromagnetischen Polrad 4.i als Wirkgröße eine Wirkspannung UW.i - oder auch Indukti-ons-Spannung - induziert werden kann. Durch eine Bewegung des Polrades 4.i wird abwechselnd ein Pol-Zahn 4a und eine Pol-Lücke 4b in das Magnetfeld eingebracht, wodurch eine Spannung in die Spulenwicklung 5b des induktiven Sensorelementes 5.i induziert wird. Je größer die Geschwindigkeit des Polrades 4.i ist, desto größer sind die Frequenz und die Amplitude der induzierten Spannung. Somit wird bei Drehung des Polrades 4.i bzw. des Rades 2.i eine oszillierende Wirkspannung UW.i erzeugt, die die Drehzahl D des Rades 2.i charakterisiert.

Die Wirkspannung UW.i wird einer Mittenspannung UM überlagert und über die Sensor-Leitungen 6a, 6b einem Auswertemodul 20 zugeführt, wobei in dem Auswertemodul 20 eine aus der Wirkspannung UW.i und der Mittenspannung UM zusammengesetzte Spannung - im Folgenden als Messspannung U.i bezeichnet - übertragen, verarbeitet und ausgewertet wird. Als Messspannung U.i wird somit die im Auswertemodul 20 wirkende Spannung bezeichnet. Die Messspannung U.i ist beispielhaft für einen Drehzahlsensor 1a.i in Fig. 1b dargestellt.

Die Mittenspannung UM wird dadurch erzeugt, dass die gemäß Fig. 1a mit der Spulenwicklung 5b verbundene erste Sensor-Leitung 6a über einen ersten Lastwiderstand R1 an einen ersten Versorgungspunkt P1, der auf einem Massepotential M liegt, angebunden ist. Die mit der Spulenwicklung 5b ebenfalls verbundene zweite Sensor-Leitung 6b ist über einen zweiten Lastwiderstand R2 an einen zweiten Versorgungspunkt P2, an dem eine gewisse Sensorspannung Usens von beispielsweise 5V anliegt, angebunden. Die Sensor-Spannung USens wird hierbei durch eine entsprechende Begrenzung der von einer ersten Energiequelle 15a gelieferten Versorgungsspannung bereitgestellt. Somit liegen beide Sensor-Leitungen 6a, 6b und somit auch die Spulenwicklung 5b immer auf einem nicht-negativen Potential, was zu einem Anheben der Wirkspannung UW.i um die Mittenspannung UM führt.

Aufgrund der vorliegenden Mittenspannung UM kann bereits ohne eine Drehung des Polrades 4.i, d. h. im Stillstand oder bei einem Blockieren des jeweiligen Rades 2.i, und demnach ohne eine in die Spulenwicklung 5b induzierte Wirkspannung UW.i im Auswertemodul 20 bereits eine Messspannung U.i gemessen werden, die im Normalbetrieb, d. h. ohne eine Funktionsstörung des Auswertemoduls 20, in etwa der Mittenspannung UM entspricht. Die Mittenspannung UM ist hierbei in diesem Ausführungsbeispiel etwas geringer als die Hälfte der Sensor-Spannung Usens.

Zur Auswertung der Messspannung U.i ist in dem Auswertemodul 20 ein Komparatormodul 7.i vorgesehen, das zwei Komparator-Eingänge 7a, 7b und zwei Komparator-Ausgänge 7c, 7d aufweist. Die Komparator-Eingänge 7a, 7b sind jeweils mit einem der Sensor-Leitungen 6a, 6b verbunden, so dass dem Komparatormodul 7.i die Messspannung U.i zugeführt und von diesem verarbeitet werden kann.

Das Komparatormodul 7.i in dem Auswertemodul 20 dient hierbei der Erzeugung einer Ausgangsgröße SK.i, UK.i, die gemäß Fig. 1b durch eine Rechteckspannung gegeben ist, die als Komparator-Spannung UK.i über einen Komparator-Ausgang 7c des Komparatormoduls 7.i ausgegeben wird, wobei die Rechteckspannung die Drehzahl D.i des Polrades 4.i und somit auch das Drehverhalten des Rades 2.i charakterisiert. Alternativ kann vom Komparatormodul 7.i auch ein Komparator-Signal SK.i ausgegeben werden, das in vergleichbarer Weise wie die Rechteckspannung die Drehzahl D.i des Polrades 4.i charakterisiert, beispielsweise in Form einer binären Zahlenfolge.

Die Komparator-Spannung UK.i oder auch das Komparator-Signal SK.i als Ausgangsgrößen des Komparatormoduls 7.i und auch des Auswertemoduls 20 können beispielsweise von einem Fahrassistenz-Steuermodul 40, das ausgebildet ist auf einen Bremsschlupffall oder einen Antriebsschlupfall mit einem Bremseingriff zu reagieren, entgegengenommen werden, um damit eine entsprechende Steuerung und/oder Regelung durchzuführen. Das Fahrassistenz-Steuermodul 40 kann hierbei direkt an der Fahrzeugachse in oder an einem der Achsmodulatoren (nicht dargestellt) oder aber separat in einem ein Bremssystem steuernden Zentralmodul (nicht dargestellt) integriert sein.

Die Komparator-Spannung UK.i ist in Fig. 1b der Messspannung U.i beispielhaft gegenübergestellt. Die Komparator-Spannung UK.i wird hierbei wie folgt erzeugt:
Ein im Komparatormodul 7.i angeordnetes elektronisches Bauelement, beispielsweise ein oder mehrere Komparatoren, oder eine vergleichbare Steuerelektronik nimmt zunächst die oszillierende Messspannung U.i auf und vergleicht diese fortlaufend mit einem Spannungs-Schwellwert U_th, der von der Mittenspannung UM ausgehend in beide Spannungs-Richtungen zeigt. Liegt eine positive Abweichung von der Mittenspannung UM um mehr als dem Spannungs-Schwellwert U_th vor, wird vom Komparatormodul 7.i eine Spannungsstufe US so lange erzeugt, bis im weiteren Verlauf der oszillierenden Messspannung U.i eine negative Abweichung von der Mittenspannung UM um ebenfalls mehr als dem Spannungs-Schwellwert U_th vorliegt. Anschließend wird die Komparator-Spannung UK.i wieder zurück auf den Ausgangswert geschaltet bis erneut die Messspannung U.i um mehr als dem Spannungs-Schwellwert U_th von der Mittenspannung UM positiv abweicht.

Dadurch wird eine Rechteckspannung erzeugt, bei der immer dann eine Spannungsstufe US auftritt, wenn ein Pol-Zahn 4a das induktive Sensorelement 5.i passiert und demnach eine Wirkspannung UW.i induziert wird, die zu einer ausreichenden Abweichung der Messspannung U.i von der Mittenspannung UM führt. Über das zeitliche Verhalten der Rechteckspannung bzw. der Komparator-Spannung UK.i unter Kenntnis der Anzahl der Pol-Zähne 4a des Polrades 4.i kann somit auf das Drehverhalten bzw. die Drehzahl D.i des jeweiligen Rades 2.i geschlossen werden. In analoger Weise kann auch das Komparator-Signal SK.i erzeugt werden.

An einem Analog-Ausgang 7d des Komparatormoduls 7.i wird die Messspannung U.i im Wesentlichen unverändert als analoge Spannung oder als analoges Mess-Signal ausgegeben. Über die Messspannung U.i oder das Mess-Signal kann eine Überwachung der Funktionsfähigkeit des induktiven Drehzahlsensors 1a.i stattfinden, indem die Messspannung U.i bzw. das Mess-Signal beispielsweise in einem Überwachungsmodul 8 mit der Kom-parator-Spannung UK.i bzw. mit dem Komparator-Signal SK.i verglichen und für eine Plausibilisierung der Komparator-Spannung UK.i bzw. des Komparator-Signals SK.i bzw. der daraus folgenden Drehzahl D.i herangezogen wird. Weiterhin kann eine Überprüfung stattfinden, ob im Stillstand des Rades 2.i die Mittenspannung UM gemessen werden kann.

Für eine Filterung der Messspannung U.i kann vor dem Komparatormodul 7.i in dem Auswertemodul 20 zusätzlich eine Filteranordnung 9 vorgesehen sein, die unerwünschte Schwankungen oder Effekte herausfiltert.

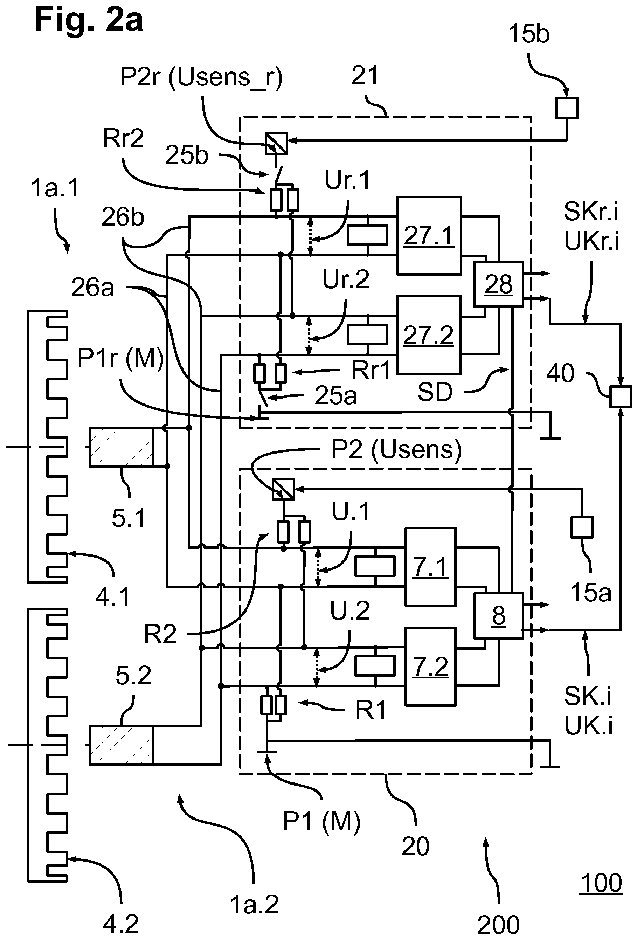

Ist mehr als ein induktiver Drehzahlsensor 1a.i vorgesehen, d. h. für i > 1, sind in entsprechender Weise für jedes induktive Sensorelement 5.i Sensor-Leitungen 6a, 6b zum Auswertemodul 20 zu führen, wobei jedem induktiven Sensorelement 5.i zur Auswertung der darüber erzeugten Wirkspannung UW.i auch ein Komparatormodul 7.i zugeordnet ist, dem die entsprechende Messspannung U.i wie beschrieben zugeführt wird. Eine Versorgung mit der Sensor-Spannung Usens erfolgt jedoch für alle induktiven Sensorelemente 5.i von denselben Versorgungspunkten P1, P2 im Auswertemodul 20 ausgehend (s. Fig. 2a), wobei jedem Sensorelement 5.i für jeden Versorgungspunkt P1, P2 jeweils ein Lastwiderstand R1, R2 zugeordnet ist, um eine Entkopplung der beiden Versorgungskreise zu erreichen.

Das oder die Komparatormodule 7.i mit den jeweiligen Komparator-Eingängen 7a, 7b und den Komparator-Ausgängen 7c, 7d, ggf. die Filteranordnung(en) 9, die Versorgungspunkte P1 (M), P2 (Usens), das Überwachungsmodul 8 sowie die jeweiligen Verbindungsleitungen zum Abgreifen und Übertragen insbesondere der jeweiligen Messspannung U.i bilden somit das gemeinsame Auswertemodul 20 des oder der induktiven Drehzahlsensoren 1a.i aus, das dazu dient, die von dem oder den induktiven Sensorelementen 5.i erzeugten Wirkspannung(en) UW.i in der oben beschriebenen Weise in Komparator-Spannung(en) UK.i oder Komparator-Signal(e) SK.i umzuwandeln, so dass basierend darauf auf eine Drehzahl D.i des jeweiligen Rades 2.i zurückgeschlossen werden kann bzw. diese für eine Fahrassistenz-Regelung herangezogen werden können.

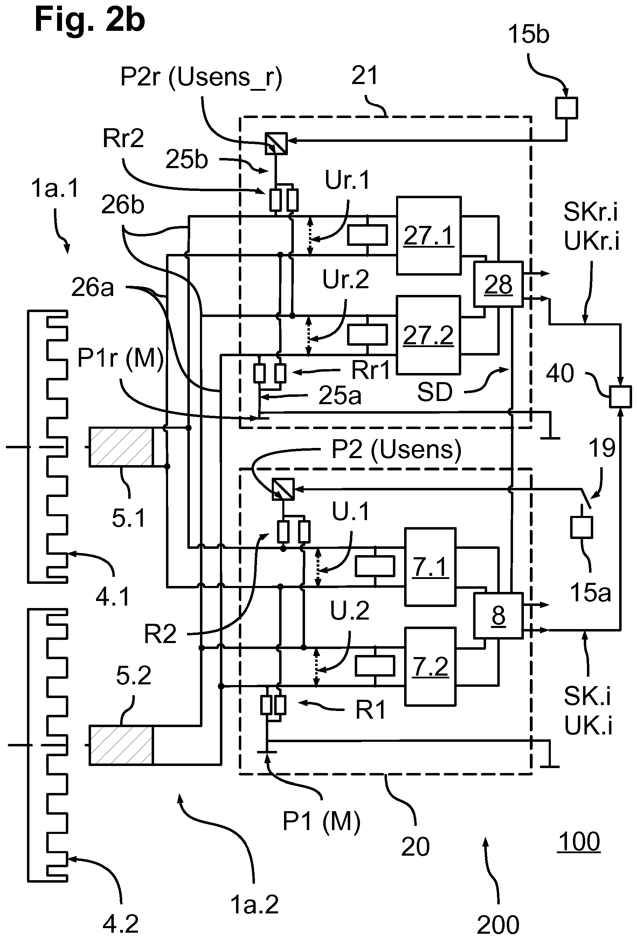

In der Ausführungsform gemäß den Figuren 2a, 2b wird eine erfindungsgemäße Sensoranordnung 200 ausgebildet, die zwei der in Fig. 1a dargestellten induktiven Drehzahlsensoren 1a.1, 1a.2 aufweist, d.h. i = 2. Die zwei Drehzahlsensoren 1a.1, 1a.2 teilen sich dabei dasselbe Auswertemodul 20, d.h. die zwei induktiven Sensorelemente 5.1, 5.2 werden von dem Auswertemodul 20 im Normalbetrieb mit einer Sensor-Spannung Usens von denselben Versorgungspunkten P1, P2 aus über die dem jeweiligen induktiven Sensorelement 5.1, 5.2 zugeordneten Lastwiderstände R1, R2 versorgt und eine dem jeweiligen induktiven Sensorelement 5.1, 5.2 zugeordnete Messspannung U.1, U.2 kann für jedes induktive Sensorelement 5.1, 5.2 separat in einem dem jeweiligen induktiven Sensorelement 5.1, 5.2 zugeordneten Komparatormodul 7.1, 7.2 ausgewertet werden. In dem jeweiligen Komparatormodul 7.1, 7.2 wird eine dem jeweiligen induktiven Sensorelement 5.1, 5.2 zugeordnete Komparator-Spannung UK.1, UK.2 oder ein Komparator-Signal SK.1, SK.2 als Ausgangsgröße wie oben beschrieben ermittelt und zur weiteren Verwendung ausgegeben. In analoger Weise können auch mehr als zwei induktive Sensorelemente 5.1, 5.2 in der Sensoranordnung 200 vorgesehen sein.

Eine Plausibilisierung erfolgt gemäß diesem Ausführungsbeispiel in einem gemeinsamen Überwachungsmodul 8, das die Ausgangsgrößen UK.1, UK.2, SK.1, SK.2 beider Komparatormodule 7.1, 7.2 überwacht, wobei diese dazu insbesondere mit der jeweiligen Messspannung U.1, U.2 wie oben beschrieben verglichen werden können.

Weiterhin ist in der Sensoranordnung 200 parallel zum Auswertemodul 20 ein Redundanzmodul 21 vorgesehen, das gemäß der Figuren 2a, 2b im Wesentlichen identisch zum Auswertemodul 20 ausgeführt ist und auch dieselbe Funktion übernehmen kann, nämlich über ein dem jeweiligen induktiven Sensorelement 5.1, 5.2 zugeordneten Redundanz-Komparatormodul 27.1, 27.2 eine Redundanz-Komparator-Spannung UKr.1, UKr.1 in Form einer Rechteckspannung oder ein entsprechendes Redundanz-Komparator-Signal SKr.1, SKr.2 zu erzeugen, die aus einer Redundanz-Messspannung Ur.1, Ur.2, die im Redundanzmodul 21 vorliegt, durch Vergleich mit einem Spannungs-Schwellwert U_th folgen. Die Eingänge und Ausgänge des jeweiligen Redundanz-Komparatormoduls 27.1, 27.2 sind identisch zum in Fig. 1a gezeigten Komparatormodul 7.1 ausgeführt.

Aus der jeweiligen Redundanz-Komparator-Spannung UKr.1, UKr.2 bzw. dem jeweiligen Redundanz-Komparator-Signal SKr.1, SKr.2 kann ebenfalls die Drehzahl D.i des jeweiligen Rades 2.i hergeleitet werden, so dass das Fahrassistenz-Steuermodul 40 auch darüber seine Steuerung und/oder Regelung durchführen kann. Sind mehr als zwei oder auch nur ein induktives Sensorelement 5.i vorgesehen, ist das Redundanzmodul 21 entsprechend wie das Auswertemodul 20 anzupassen.

Um dem Redundanzmodul 21 die Redundanz-Messspannung Ur.1, Ur.2, die im Wesentlichen der im Auswertemodul 20 vorherrschenden Messspannung U.1, U.2 entspricht, zuzuführen, sind für jeden der induktiven Sensorelemente 5.1, 5.2 Redundanz-Leitungen 26a, 26b vorgesehen, die wie in Fig. 2a, 2b dargestellt mit den Sensor-Leitungen 6a, 6b (vgl. Fig. 1a) gleichgeschaltet sind und somit dieselbe Spannung übertragen. Somit werden die jeweiligen der Mittenspannung UM überlagerten Wirkspannungen UW.i des jeweiligen induktiven Sensorelementes 5.1, 5.2 über die Redundanz-Leitungen 26a, 26b als Redundanz-Messspannung Ur.1, Ur.2 auch an das Redundanzmodul 21 bzw. das jeweilige darin befindliche Redundanz-Komparatormodul 27.1, 27.2 übertragen, um diese entsprechend verarbeiten zu können. Für die Mittenspannung UM sorgt im Normalbetrieb wie oben beschrieben die in dem Auswertemodul 20 bereitgestellte Sensor-Spannung Usens.

Um im Normalbetrieb die in dem Auswertemodul 20 vorherrschende Messspannung U.1, U.2 nicht maßgeblich durch den Betrieb des Redundanzmoduls 21 zu beeinflussen, werden in dem Redundanzmodul 21 vorhandene Redundanz-Versorgungspunkte P1r, P2r, über die im Bedarfsfall über Redundanz-Lastwiderstände Rr1, Rr2 eine Redundanz-Sensor-Spannung Usens_r zur Versorgung der induktiven Sensorelemente 5.1, 5.2 vorgegeben werden kann, von der jeweiligen Redundanz-Leitung 26a, 26b getrennt, indem elektrische Schalter 25a, 25b entsprechend geöffnet werden. Dadurch werden die Redundanz-Leitungen 26a, 26b nicht zusätzlich zu den Versorgungspunkten P1, P2 im Auswertemodul 20 auf ein Potential gelegt. Dadurch kann eine doppelte Versorgung der zwei induktiven Sensorelemente 5.1, 5.2 und somit eine gegenseitige elektrische Beeinflussung vermieden werden.

Im Normalbetrieb befindet sich das Redundanzmodul 21 demnach in einem passiven Betriebsmodus, in dem die Wirkspannung UW.i des jeweiligen induktiven Sensorelementes 5.i über die jeweilige Redundanz-Messspannung Ur.i lediglich "beobachtet" wird und eine Versorgung des jeweiligen induktiven Sensorelementes 5.i nicht über das Redundanzmodul 21 stattfindet. Das Auswertemodul 20 hingegen befindet sich in einem aktiven Betriebsmodus, in dem sowohl eine Beobachtung der jeweiligen Wirkspannung UW.i über die jeweilige Messspannung U.i sowie auch eine Versorgung des jeweiligen induktiven Sensorelementes 5.i über die Sensor-Spannung Usens stattfindet.

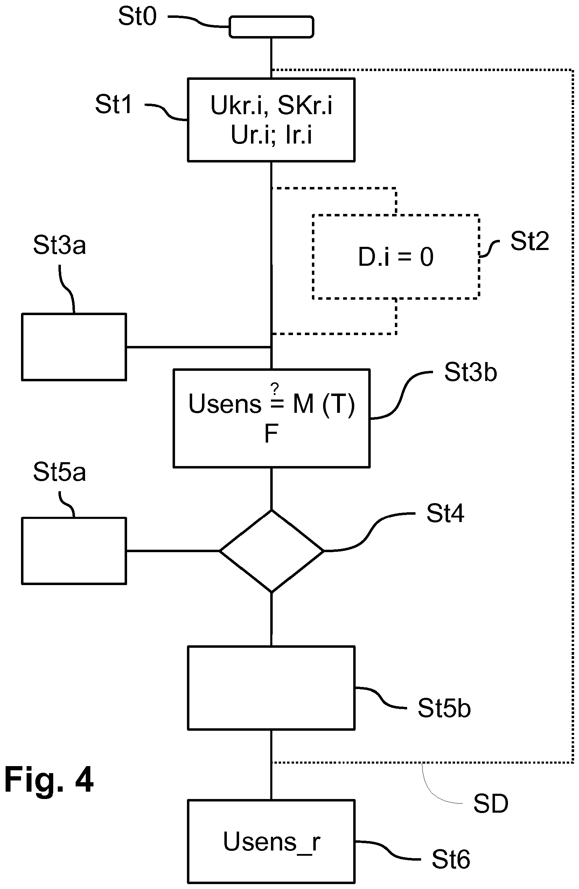

Um im Betrieb des jeweiligen induktiven Drehzahlsensors 1a.i eine Versorgung des induktiven Sensorelementes 5.i mit einer Spannung sicherzustellen und auch eine Auswertung der Wirkspannung UW.i und damit ein Erfassen und Weiterverarbeiten der Drehzahl D.i des jeweiligen Rades 2.i zu ermöglichen, findet durch das Redundanzmodul 21, vorzugsweise durch ein in dem Redundanzmodul 21 integriertes Redundanz-Überwachungsmodul 28, eine Überwachung der Funktionsfähigkeit des Auswertemoduls 20 statt, was in dem Flussdiagramm gemäß Fig. 4 beispielhaft dargestellt ist:
Nachdem das System in einem anfänglichen Schritt St0 initialisiert wurde, kann in dem Redundanz-Überwachungsmodul 28 gemäß einer Ausbildung die aus einem der Redundanz-Komparatormodule 27.i ausgegebene analoge Redundanz-Messspannung Ur.i sowie die Redundanz-Komparator-Spannung UKr.i - oder das Redundanz-Komparator-Signal SKr.i - zunächst für ein bestimmtes induktives Sensorelement 5.i überwacht werden, wobei dazu in einem ersten Schritt St1 zunächst eine Plausibilisierung durchgeführt werden kann. D. h. es wird zunächst ermittelt, ob die Redundanz-Messspannung Ur.i zur ausgegebenen Redundanz-Komparator-Spannung UKr.i des jeweiligen induktiven Sensorelementes 5.i passt.

Dazu können unterschiedliche Kriterien angesetzt werden, beispielsweise, ob ein Spannungswert der analogen Redundanz-Messspannung Ur.i zur aus der Redundanz-Komparator-Spannung UKr.i ermittelten Drehzahl D.i passt, wobei bei einer höheren Drehzahl D.i ein höherer Spannungswert der analogen Redundanz-Messspannung Ur.i zu erwarten ist. Dieser Zusammenhang kann beispielsweise in einer Kennlinie in dem Redundanz-Überwachungsmodul 28 abgespeichert sein. Weiterhin kann auch geprüft werden, ob überhaupt plausible Redundanz-Spannungen Ur.i, UKr.i ausgegeben werden, d.h. überhaupt eine plausible bzw. sinnvolle Drehzahl D.i für das jeweilige induktive Sensorelement 5.i ermittelt werden kann.

Sind die beiden redundanten Spannungen Ur.i, UKr.i - oder das Signal SKr.i - für das jeweilige Sensorelement 5.i plausibel und wurde gleichzeitig erkannt, dass eine Drehzahl D.i von Null vorliegt, d. h. eine Redundanz-Komparator-Spannung UKr.i in einem bestimmten Zeitrahmen ohne Spannungsstufen US vorliegt, weil sich das jeweilige Rad 2.i im Stillstand befindet oder gerade blockiert, wird in einem zweiten Schritt St2 geprüft, ob die diesem Rad 2.i zugeordnete Redundanz-Messspannung Ur.i der aufgrund der Sensor-Spannung Usens erzeugten Mittenspannung UM entspricht. Daraus kann bei einer Drehzahl D.i von Null geschlussfolgert werden, ob die Sensor-Spannung Usens von dem Auswertemodul 20 über die Versorgungspunkte P1, P2 an das jeweilige induktive Sensorelement 5.i vorgegeben wird oder nicht.

Ist dies der Fall, kann davon ausgegangen werden, dass der jeweilige induktive Drehzahlsensor 1a.i bzw. das jeweilige induktive Sensorelement 5.i mit einer Sensorspannung Usens versorgt wird und demnach korrekt funktioniert (St3a).

Wird jedoch im zweiten Schritt St2 - oder auch bereits im ersten Schritt St1 - festgestellt, dass der Mittelwert der Redundanz-Messspannung Ur.i innerhalb einer Fehlertoleranz T von beispielsweise 500mV dem Massepotential M entspricht, wird in einem dritten Schritt St3b auf einen Fehlerfall F geschlossen.

Um entsprechend einzugreifen, wird in den folgenden Schritten bewertet, ob das jeweilige induktive Sensorelement 5.i entweder einen Sensorfehler aufweist oder nicht mehr von dem Auswertemodul 20 mit der Sensor-Spannung Usens versorgt wird, weil beispielsweise das Auswertemodul 20 einen Defekt bzw. eine Funktionsstörung aufweist, wobei dazu gemäß dieser Ausbildung auf weitere induktive Sensorelemente 5.i zurückgegriffen wird.

Um unterscheiden zu können, ob ein Sensorfehler oder eine fehlende Sensor-Spannung Usens vorliegt, wird von dem Redundanz-Überwachungsmodul 28 in einem vierten Schritt St4 für mindestens ein weiteres induktives Sensorelement 5.i der Sensoranordnung 200, das ebenfalls wie beschrieben und in Fig. 2a, 2b dargestellt an das Redundanzmodul 21 angeschlossen ist und das ebenso von dem Auswertemodul 20 mit einer Sensor-Spannung Usens versorgt werden müsste, geprüft, ob auch die diesem induktiven Sensorelement 5.i zugeordnete Redundanz-Messspannung Ur.i dem Massepotential M innerhalb der Toleranz T entspricht.

Wird also beispielsweise im dritten Schritt St3b ein Fehlerfall F erkannt, weil die dem einen induktiven Sensorelement 5.1 in Fig. 2a zugeordnete Redundanz-Messspannung Ur.1 dem Massepotential M innerhalb der Toleranz T entspricht, so wird im vierten Schritt St4 geprüft, ob auch die dem anderen induktiven Sensorelement 5.2 in Fig. 2a zugeordnete Redundanz-Messspannung Ur.2 dem Massepotential M innerhalb der Toleranz T entspricht.

Ist dies für alle von dem Auswertemodul 20 mit der Sensor-Spannung Usens versorgten und für alle gleichzeitig an das Redundanzmodul 21 angeschlossenen induktiven Sensorelemente 5.i der Fall, so wird in einem fünften Schritt St5b darauf geschlossen, dass ein Ausfall der Versorgung der einzelnen induktiven Sensorelemente 5.i mit der Sensorspannung Usens vorliegen könnte. D. h. es wird festgestellt, dass aufgrund einer beliebigen Funktionsstörung des Auswertemoduls 20 die Sensor-Spannung Usens nicht über die Sensor-Leitungen 6a, 6b an alle induktiven Sensorelemente 5.i der Sensoranordnung 200 übertragen werden kann.

Sind hingegen nur einzelne induktive Sensorelemente 5.i, die alle von demselben Auswertemodul 20 mit der Sensor-Spannung Usens versorgt werden, davon betroffen, so wird in einem alternativen fünften Schritt St5a auf eine andere Funktionsstörung, ggf. einen Sensordefekt, geschlossen und eine entsprechende Warnung ausgegeben. Entspricht demnach die eine Redundanz-Messspannung Ur.1 in Fig. 2a dem Massepotential M und die andere Redundanz-Messspannung Ur.2 innerhalb der Toleranz T nicht dem Massepotential M sondern beispielsweise der Mittenspannung UM, so liegt mit hoher Wahrscheinlichkeit keine Funktionsstörung des Auswertemoduls 20 im Hinblick auf die Versorgung mit der Sensor-Spannung Usens vor. In dieser Alternative kann im Rahmen des erfindungsgemäßen Verfahrens keine Rückfallebene ausgebildet werden.

Um bei Vorliegen einer hohen Wahrscheinlichkeit für einen Ausfall der Versorgung der einzelnen induktiven Sensorelemente 5.i über die von dem Auswertemodul 20 bereitgestellten Sensor-Spannung Usens dennoch einen weiteren Betrieb des oder der induktiven Drehzahlsensoren 1a.i zu gewährleisten, werden in einem sechsten Schritt St6 wie in Fig. 2b dargestellt die elektrischen Schalter 25a, 25b geschlossen und die Redundanz-Versorgungspunkte P1r, P2r mit den Redundanz-Leitungen 26a, 26b verbunden, so dass für die einzelnen induktiven Sensorelemente 5.i eine Redundanz-Sensor-Spannung Usens_r bereitgestellt wird. Das Öffnen der Schalter 25a, 25b kann hierbei beispielsweise durch das Redundanz-Überwachungsmodul 28 stattfinden, dass die elektrischen Schalter 25a, 25b elektrisch ansteuern kann.

In dem Fall übernimmt also das Redundanzmodul 21 die volle Funktion (Versorgung und Verarbeitung) des als für defekt befundenen Auswertemoduls 20 und die von dem Redundanzmodul 21 ausgegebene Redundanz-Komparator-Spannung UKr.i für das jeweilige induktive Sensorelement 5.i kann für die Steuerung und/oder Regelung in dem Fahrassistenz-Steuermodul 40 verwendet werden. Auch weitere Funktionen des Auswertemoduls 20, beispielsweise weitere Diagnosefunktionen, können aufgrund des nahezu identischen Aufbaus und der nahezu identischen Funktionsweise von dem Redundanzmodul 21 übernommen werden.

Somit wird also in dieser Ausbildung über weitere induktive Sensorelemente 5.i der Sensoranordnung 200 auf eine Funktionsfähigkeit des Auswertemoduls 20 geschlossen. Mit lediglich einem induktiven Sensorelement 5.i ist dieses Überwachen somit nicht möglich. Vielmehr sind mindestens zwei induktive Sensorelemente 5.i erforderlich.

Alternativ oder ergänzend kann allerdings in einer Ausbildung auch vorgesehen sein, dass die Übernahme der Funktionen durch das Redundanzmodul 21 im Schritt St6 bereits dann erfolgt, wenn das Auswertemodul 20 in einen Fehlermodus umgeschaltet wird, ohne dass dabei die vorherigen Schritte St1 bis St5 durchzuführen sind. Dies kann erfolgen, wenn das Auswertemodul 20 in einer Selbstdiagnose erkennt, dass ein Fehler bzw. eine Funktionsstörung vorliegt und infolge dessen eine Verbindung zur ersten Energiequelle 15a selbsttätig abgeschaltet wird, um wie in Fig. 2b durch einen Versorgungsschalter 19 angedeutet in den passiven Betriebsmodus umzuschalten. Diese Variante wird durch den parallelen Pfad in Fig. 4 dargestellt, d.h. parallel zu den Schritten St1 bis St5 kann immer auch das Diagnose-Signal SD ausgelesen und beurteilt werden.

In dem Fall kann das Auswertemodul 20 dem Redundanzmodul 21 über ein Diagnose-Signal SD melden, dass eine Funktionsstörung vorliegt und das Auswertemodul 20 in den passiven Betriebsmodus übergeht, in dem somit auch keine Sensor-Spannung Usens ausgegeben wird. In dem Fall findet also ebenfalls eine Überwachung der Funktionsfähigkeit des Auswertemoduls 20 über das Diagnose-Signal SD statt und durch ein Umschalten der elektrischen Schalter 25a, 25b kann das Redundanzmodul 21 die Versorgung und Auswertung und somit den vollen Betrieb des oder der induktiven Drehzahlsensor(en) 1a.i übernehmen. In dem Fall kann in der Sensoranordnung 200 eine beliebige Anzahl an induktiven Sensorelementen 5.i mit i >= 1 vorhanden sein, d.h. auch lediglich ein induktives Sensorelement 5.1, da die Erkennung der Funktionsfähigkeit des Auswertemoduls 20 nicht über weitere induktive Sensorelemente 5.i überwacht wird.

Dadurch kann in beiden Ausführungen in einem elektrisch gesteuerten Bremssystem eine Rückfallebene ausgebildet werden, die dann eingreift, wenn die Versorgung der induktiven Sensorelemente 5.i durch das Auswertemodul 20 fehlschlägt, was durch das Redundanzmodul 21 selbst in einfacher Weise erkannt werden kann.

Die Energieversorgung des Auswertemoduls 20 und des Redundanzmoduls 21 erfolgt hierbei getrennt voneinander über zwei Energiequellen 15a, 15b, die unabhängig voneinander sind, so dass bei einem Defekt in einer ersten Energiequelle 15a, die das Auswertemodul 20 mit Energie versorgt, eine zweite Energiequelle 15b, die das Redundanzmodul 21 mit Energie versorgt, davon unbeeinflusst bleibt. Dies wird beispielsweise durch eine galvanische Trennung bei Verwendung lediglich einer Energieversorgung, beispielsweise einer Fahrzeugbatterie oder einer Lichtmaschine, erfolgen oder durch das Vorsehen zweier separater Energiequellen 15a, 15b. Die Energiequellen 15a, 15b sorgen hierbei dafür, dass das jeweilige Modul 20, 21 die Redundanz-/Sensors-Spannung Usens, Usens_r bereitstellen kann und dass das Redundanz-/Komparatormodul 7.i, 27.i sowie das Redundanz-/Überwachungsmodul 8, 28 entsprechend ihrer Funktionsweise die jeweiligen Spannungen und/oder Signale auswerten und verarbeiten können.

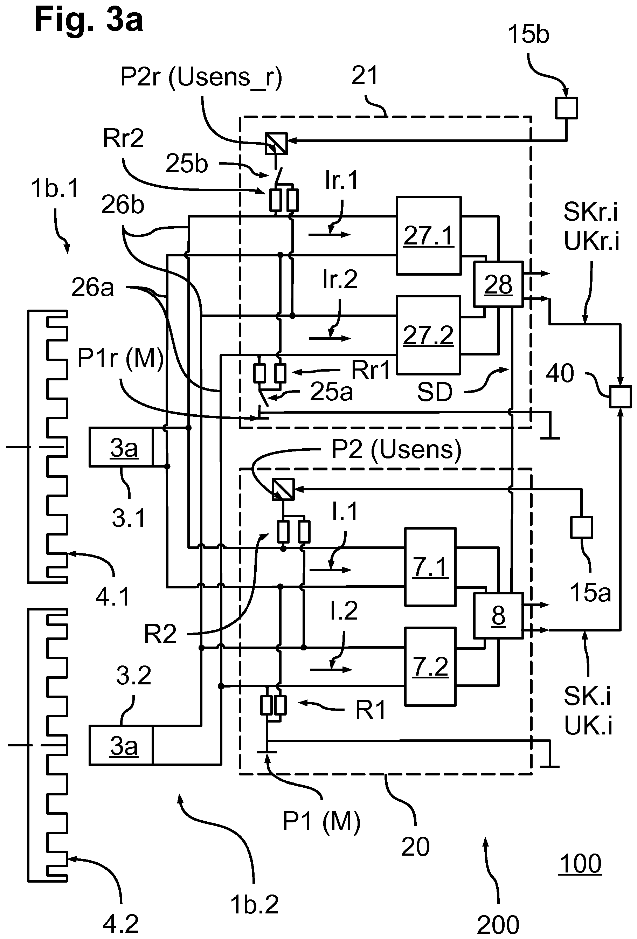

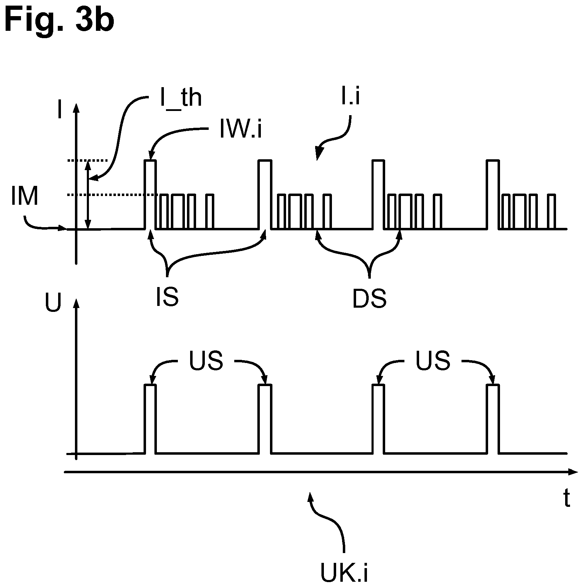

Gemäß Figur 3a ist eine weitere Ausführung der Sensoranordnung 200 mit zwei aktiven Drehzahlsensoren 1b.i schematisch dargestellt. In diesem Fall liegt an dem entsprechenden Rad 2.i ein aktives Sensorelement 3.i vor, das beispielsweise als ein Hall-Sensorelement 3a ausgeführt ist. In diesem wird bei Annäherung eines Pol-Zahnes 4a des Polrades 4.i eine Veränderung eines das aktive Sensorelement 3.i durchströmenden Wirkstromes IW.i verursacht. Aufgrund der an den Versorgungspunkten P1, P2 des Auswertemoduls 20 vorherrschenden Potentialen M, Usens bzw. der über die Sensor-Leitungen 6a, 6b im Normalbetrieb auf das aktive Sensorelement 3.i über die Lastwiderstände R1, R2 wirkenden Sensor-Spannung Usens wird dem Wirkstrom IW.i als Wirkgröße ein Mittenstrom IM überlagert. Diese Überlagerung wird als Messstrom l.i über die Sensor-Leitungen 6a, 6b an das Auswertemodul 20 übertragen und von dem jeweiligen Komparatormodul 7.i aufgenommen. Beispielhaft ist ein derartiger Messstrom l.i als Messgröße in Fig. 3b dargestellt.

Ist das aktive Sensorelement 3.i ausgebildet, über ein VDA-AK-Protokoll weiteren Sensor-Informationen auszugeben, können diese zusätzlich für eine Diagnose herangezogen werden. In dem Fall werden die Sensor-Informationen entsprechend in der Messgröße kodiert übertragen, wobei dazu gemäß Fig. 3b im Anschluss an einen im Wirkstrom IW.i auftretenden Sensor-Strompuls IS, der aufgrund der Wechselwirkung des Polrades 4.i mit dem aktiven Sensorelement 3.i auftritt und der größer gleich einem Strom-Schwellwert l_th ist, zusätzliche Diagnose-Strompulse DS unterschiedlicher zeitlicher Ausdehnung und mit in etwa dem halbem Strom-Schwellwert l_th übertragen werden. Über die zeitliche Ausdehnung der Diagnose-Strompulse DS können hierbei gewisse Sensor-Informationen, die insbesondere auf einen Zustand des aktiven Drehzahlsensors 1b.i hinweisen, übertragen werden.

Die Funktionsweise des Auswertemoduls 20 ist analog zu dem bereits beschriebenen Auswertemodul 20 für ein induktives Sensorelement 5.i gemäß der Figuren 1a, 2a und 2b. Demnach wird der dem jeweiligen aktiven Sensorelement 3.i zugeordnete Messstrom l.i von dem jeweiligen Komparatormodul 7.i mit dem Strom-Schwellwert l_th verglichen. Kann auf ein Passieren des Pol-Zahnes 4a am jeweiligen aktiven Sensorelement 3.i geschlossen werden, was in Fig. 3b immer bei einem Sensor-Strompuls IS in dem Messstrom l.i der Fall ist, wird ein entsprechender Spannungspuls US erzeugt und in einer Komparator-Spannung UK.i vom Komparatormodul 7.i zur weiteren Verarbeitung und Überwachung ausgegeben. Daraus kann wie auch für ein induktives Sensorelement 5.i bereits beschrieben unter Kenntnis der Anzahl an Pol-Zähnen 4a auf die Drehzahl D.i des Polrades 4.i bzw. des Rades 2.i geschlossen werden. Weiterhin kann aus dem Messstrom l.i im Komparatormodul 7.i auch eine entsprechende analoge Spannung erzeugt und als Messspannung U.i am Analog-Ausgang 7d des Komparatormoduls 7.i ausgegeben werden.

Auch der Aufbau und die Funktionsweise des Redundanzmoduls 21 ist analog zur Ausführung der Sensoranordnung 200 mit induktiven Sensorelementen 5.i, d. h. im Normalbetrieb ist das Redundanzmodul 21 zunächst passiv und beobachtet den Redundanz-Messstrom lr.i, der in das Redundanzmodul 21 über die Redundanz-Leitungen 26a, 26b eingespeist wird, bzw. eine daraus im Redundanz-Komparatormodul 27.i erzeugte Redundanz-Messspannung Ur.i sowie die ebenfalls vom Redundanz-Komparatormodul 27.i ausgegebene Redundanz-Komparator-Spannung UKr.i bzw. das Redundanz-Komparator-Signal Skr.i, die jeweils die Drehzahl D.i charakterisieren.

Bei Vorliegen der entsprechenden Variante des aktiven Sensorelementes 3.i mit dem VDA-AK-Protokoll können ergänzend die aus den Diagnose-Strompulsen DS übermittelten Sensor-Informationen überwacht werden.

Damit stehen dieselben oder vergleichbare Größen wie für die bereits beschriebene induktive Ausführung der Sensoranordnung 200 zur Verfügung und das in Fig. 4 angegebene Verfahren kann in analoger Weise im Redundanz-Überwachungsmodul 28 durchgeführt werden, um eine Funktion des Auswertemoduls 20 im Hinblick auf eine Versorgung der in dem Fall aktiven Sensorelemente 3.i mit der Sensor-Spannung Usens zu überwachen.

Zum einen kann dies nach erfolgter Plausibilisierung der Ströme bzw. Spannungen (vgl. St1) durch Überwachen des Mittenstroms IM geschehen, wobei der Mittenstrom IM bei einem Wegfall der vom Auswertemodul 20 bereitgestellten Sensor-Spannung Usens innerhalb der Fehlertoleranz T auf Null abfällt, was einer Versorgung des aktiven Sensorelementes 3.i mit dem Massepotential M innerhalb der Fehlertoleranz T entspricht. (vgl. St2, St3b).

Wird dies für alle aktiven Sensorelemente 3.i der Sensoranordnung 200 erkannt (vgl. St4, St5b), kann das Redundanzmodul 21 den Betrieb des aktiven Drehzahlsensors 1b.i übernehmen und entsprechend für eine Versorgung sowie eine Auswertung sorgen (vgl. St6).

Zum anderen kann aber auch die Überwachung über das Diagnose-Signal SD erfolgen und das Redundanzmodul 21 bei Meldung einer Funktionsstörung redundant eingreifen.

Wird das VDA-AK-Protokoll für den aktiven Drehzahlsensor 1b.i unterstützt, können ergänzend bei der Überwachung auch die Sensor-Informationen berücksichtigt werden. Beispielsweise kann auch erfasst werden, ob die Diagnose-Strompulse DS über den Redundanz-Messstrom Ir.i übertragen werden und aufgrund dessen kann erkannt werden, ob eine Versorgung der aktiven Sensorelemente 3.i erfolgt, da bei Wegfall der Versorgung auch keine Diagnose-Strompulse DS mehr erfasst werden können.

### Bezugszeichenliste (Teil der Beschreibung)

- 1a.i: induktiver Drehzahlsensor
- 1b.i: aktiver Drehzahlsensor
- 2.i: Rad
- 3.i: aktives Sensorelement
- 3a: Hall-Sensorelement
- 4.i: Polrad
- 4a: Pol-Zahn
- 4b: Pol-Lücke
- 5.i: induktives Sensorelement
- 5a: magnetischer Kern
- 5b: Spulenwicklung
- 6a, 6b: Sensor-Leitungen
- 7.i: Komparatormodul
- 7a, 7b: Komparator-Eingänge
- 7c: Komparator-Ausgang
- 7d: Analog-Ausgang
- 8: Überwachungsmodul
- 9: Filteranordnung
- 15a, 15b: Energiequelle
- 19: Versorgungssschalter
- 20: Auswertemodul
- 21: Redundanzmodul
- 25a, 25b: elektrische Schalter
- 26a, 26b: Redundanz-Leitungen
- 27.i: Redundanz-Komparatormodul
- 28: Redundanz-Überwachungsmodul
- 40: Fahrassistenz-Steuermodul
- 100: Fahrzeug
- 200: Überwachungsanordnung
- A: Abstand
- D.i: Drehzahl
- DS: Diagnose-Strompuls
- F: Fehlerfall
- l_th: Strom-Schwellwert
- I.i: Messstrom
- IM: Mittenstrom
- Ir.i: Redundanz-Messstrom
- IS: Sensor-Strompuls
- IW.i: Wirkstrom
- M: Massepotential
- P1: erster Versorgungspunkt
- P1r: erster Redundanz-Versorgungspunkt
- P2: zweiter Versorgungspunkt
- P2r: zweiter Redundanz-Versorgungspunkt
- R1, R2: Lastwiderstände
- Rr1, Rr2: Redundanz-Lastwiderstände
- SD: Diagnose-Signal
- T: Fehlertoleranz
- UW.i: Wirkspannung
- UK: Komparator-Spannung
- UKr: Redundanz-Komparator-Spannung
- U.i: Messspannung
- Ur.i: Redundanz-Messspannung
- UM: Mittenspannung
- US: Spannungspuls
- Usens: Sensor-Spannung
- Usens_r: Redundanz-Sensor-Spannung
- U_th: Spannungs-Schwellwert

- St0, St1, St2, St3a, St3b, St4, St5a, St5b, St6: Schritte des Verfahrens

## Patentansprüche

1. Verfahren zum Betreiben eines ein Sensorelement (5.i; 3.i) aufweisenden Drehzahlsensors (1a.i; 1b.i) in einem Fahrzeug (100), insbesondere Nutzfahrzeug, wobei das Sensorelement (5.i; 3.i) mit einem Polrad (4.i) an einem Rad (2.i) des Fahrzeuges (100) wechselwirkt und eine durch die Wechselwirkung des Polrades (4.i) mit dem Sensorelement (5.i; 3.i) erzeugte Wirkgröße (UW.i; IW.i) in Form einer Messgröße (U.i; I.i) in einem Auswertemodul (20) ausgewertet und in Abhängigkeit der Messgröße (U.i; I.i) eine eine Drehzahl (D.i) des Rades (2.i) charakterisierende Ausgangsgröße (UK.i, SK.i) ausgegeben wird, wobei das Sensorelement (5.i; 3.i) über das Auswertemodul (20) mit einer die Messgröße (U.i, I.i) beeinflussenden Sensor-Spannung (Usens) versorgt wird,
wobei die Funktionsfähigkeit des Auswertemoduls (20) durch ein vom Auswertemodul (20) unabhängiges Redundanzmodul (21) dahingehend überwacht wird, ob das Sensorelement (5.i; 3.i) von dem Auswertemodul (20) mit der Sensor-Spannung (Usens) versorgt wird oder werden kann, wobei bei einer Funktionsstörung des Auswertemoduls (20), infolge derer das Sensorelement (5.i; 3.i) nicht mehr von dem Auswertemodul (20) mit der Sensor-Spannung (Usens) versorgt wird oder werden kann, eine Redundanz-Sensor-Spannung (Usens_r) von dem Redundanzmodul (21) bereitgestellt wird, mit der das jeweilige Sensorelement (5.i; 3.i) stattdessen versorgt wird (St6) zum Ausbilden einer redundanten Spannungsversorgung des Sensorelementes (5.i; 3.i), wobei im Redundanzmodul (21) um die Funktionsfähigkeit des Auswertemoduls (20) zu überwachen mindestens die folgenden Schritte durchgeführt werden:
- Erfassen einer sich in dem Redundanzmodul (21) einstellenden Redundanz-Messgröße (Ur.i; Ir.i), wobei sich die Redundanz-Messgröße (Ur.i; Ir.i) aufgrund der Wechselwirkung des Polrades (4) mit dem Sensorelement (5.i; 3.i), das mit der von dem Auswertemodul (20) vorgegebenen Sensor-Spannung (Usens) versorgt wird, ergibt; und
- Ermitteln, ob die Redundanz-Messgröße (Ur.i; Ir.i) darauf hinweist, dass eine Sensor-Spannung (Usens) vorliegt, die innerhalb einer Fehlertoleranz (T) einem Massepotential (M) entspricht,
**dadurch gekennzeichnet, dass**
bei Vorliegen einer Redundanz-Messgröße (Ur.i; Ir.i), die auf eine Sensor-Spannung (Usens) hinweist, die innerhalb der Fehlertoleranz (T) einem Massepotential (M) entspricht, auf eine Funktionsstörung des Auswertemoduls (20) geschlossen wird, infolge derer das Sensorelement (5.i; 3.i) nicht mehr von dem Auswertemodul (20) mit der Sensor-Spannung (Usens) versorgt wird oder werden kann,
erst wenn eine Redundanz-Messgröße (Ur.i; Ir.i), die mindestens einem weiteren Sensorelement (5.i; 3.i) mindestens eines weiteren Drehzahlsensors (1a.i; 1b.i) derselben Sensoranordnung (200) zugeordnet ist, ebenfalls auf eine Sensor-Spannung (Usens) hinweist, die innerhalb der Fehlertoleranz (T) einem Massepotential (M) entspricht, wobei das mindestens eine weitere Sensorelement (5.i; 3.i) ebenfalls von demselben Auswertemodul (20) mit der Sensor-Spannung (Usens) versorgt und ebenfalls von dem Redundanzmodul (21) auf eine Funktionsstörung überwacht wird.

2. Verfahren nach Anspruch 1, **dadurch gekennzeichnet, dass** bei einer Funktionsstörung des Auswertemoduls (20), infolge derer das Sensorelement (5.i; 3.i) nicht mehr von dem Auswertemodul (20) mit der Sensors-Spannung (Usens) versorgt wird oder werden kann, die durch die Wechselwirkung des Polrades (4.i) mit dem Sensorelement (5.i; 3.i) erzeugte Wirkgröße (UW.i; IW.i) in Form einer Redundanz-Messgröße (Ur.i; Ir.i) in dem Redundanzmodul (21) ausgewertet wird, und in Abhängigkeit der Redundanz-Messgröße (Ur.i; Ir.i) eine die Drehzahl (D.i) des Rades (2.i) charakterisierende Redundanz-Ausgangsgröße (UKr.i, SKr.i) durch das Redundanzmodul (21) ausgegeben wird zum Ausbilden einer redundanten Auswertung.

3. Verfahren nach Anspruch 1 oder 2, **dadurch gekennzeichnet, dass** bei einer Funktionsstörung des Auswertemoduls (20), infolge derer das Sensorelement (5.i; 3.i) nicht mehr von dem Auswertemodul (20) mit der Sensors-Spannung (Usens) versorgt wird oder werden kann, Redundanz-Versorgungspunkte (P1r, P2r) des Redundanzmoduls (21) derartig über Redundanz-Leitungen (26a, 26b) mit dem Sensorelement (5.i; 3.i) elektrisch leitend verbunden werden, dass das Sensorelement (5.i; 3.i) mit einer von den Redundanz-Versorgungspunkten (P1r, P2r) bereitgestellten Redundanz-Sensor-Spannung (Usens_r) versorgt wird, und die Redundanz-Versorgungspunkte (P1r, P2r) sonst von dem Sensorelement (5.i; 3.i) elektrisch getrennt sind.

4. Verfahren nach Anspruch 3, **dadurch gekennzeichnet, dass** das Ausbilden der Verbindung der Redundanz-Versorgungspunkte (P1r, P2r) mit dem Sensorelement (5.i; 3.i) und das Trennen der Redundanz-Versorgungspunkte (P1r, P2r) von dem Sensorelement (5.i; 3.i) über elektrische Schalter (25a, 25b) erfolgt, wobei die elektrischen Schalter (25a, 25b) in Abhängigkeit der Funktionsfähigkeit des Auswertemoduls (20) geöffnet oder geschlossen werden.

5. Verfahren nach Anspruch 1, **dadurch gekennzeichnet, dass** das Redundanzmodul (21) ein von dem Auswertemodul (20) ausgegebenes Diagnose-Signal (SD) überwacht, wobei das Diagnose-Signal (SD) angibt, ob das Sensorelement (5.i; 3.i) über das Auswertemodul (20) mit der Sensor-Spannung (Usens) versorgt wird oder werden kann.

6. Verfahren nach einem der vorherigen Ansprüche, **dadurch gekennzeichnet, dass** bei einem erkannten Stillstand des Rades (2.i) zusätzlich ermittelt wird, ob die Redundanz-Messgröße (Ur.i; Ir.i) einer Mittenspannung (UM) und/oder einem Mittenstrom (IM) entspricht, die sich im Stillstand des Rades (2.i) aufgrund der Versorgung des Sensorelementes (5.i; 3.i) mit der Sensor-Spannung (Usens) ohne eine Wechselwirkung des Sensorelementes (5.i; 3.i) mit dem Polrad (4.i) einstellt.

7. Verfahren nach einem der vorherigen Ansprüche, **dadurch gekennzeichnet, dass** die Redundanz-Messgröße (Ur.i; Ir.i) nach dem Erfassen zunächst plausibilisiert wird, wobei dazu aus der Redundanz-Messgröße (Ur.i; Ir.i) in einem Redundanz-Komparatormodul (27.i) des Redundanzmoduls (21) als Ausgangsgröße eine Redundanz-Komparator-Spannung (Ukr.i) oder ein Redundanz-Komparator-Signal (SK.i) erzeugt wird, die jeweils angeben, ob die Redundanz-Messgröße (Ur,i; Ir.i) infolge einer Wechselwirkung des Sensorelementes (5.i; 3.i) mit einem Pol-Zahn (4a) des Polrades (4.i) um mehr als einen Schwellwert (U_th; I_th) von der Mittenspannung (UM) oder dem Mittenstrom (IM) abweicht, und die Redundanz-Messgröße (Ur.i; Ir.i) mit der Redundanz-Komparator-Spannung (UKr.i) oder dem Redundanz-Komparator-Signal (SKr.i) verglichen wird zum Erfassen von Inkonsistenzen in der erfassten Redundanz-Messgröße (Ur.i; Ir.i).

8. Verfahren nach einem der vorhergehenden Ansprüche, **dadurch gekennzeichnet, dass**
- in dem Auswertemodul (20) als Messgröße eine Messspannung (U.i) und in dem Redundanzmodul (21) als Redundanz-Messgröße eine Redundanz-Messspannung (Ur.i) verarbeitet werden, wobei die Messspannung (U.i) und die Redundanz-Messspannung (Ur.i) aus der Wechselwirkung des Polrades (4.i) mit dem Sensorelement (5.i; 3.i) überlagert mit einer aus der Sensor-Spannung (Usens) oder bei erkannter Funktionsstörung aus der Redundanz-Sensor-Spannung (Usens_r) folgenden Mittenspannung (UM) folgt oder
- in dem Auswertemodul (20) als Messgröße ein Messstrom (I.i) und in dem Redundanzmodul (21) als Redundanz-Messgröße ein Redundanz-Messstrom (Ir.i) verarbeitet werden, wobei der Messstrom (I.i) und der Redundanz-Messstrom (Ir.i) aus der Wechselwirkung des Polrades (4.i) mit dem Sensorelement (5.i; 3.i) überlagert mit einem aus der Sensor-Spannung (Usens) oder bei erkannter Funktionsstörung aus der Redundanz-Sensor-Spannung (Usens_r) folgenden Mittenstrom (IM) folgt.

9. Verfahren nach Anspruch 8, **dadurch gekennzeichnet, dass**
- sich die Messspannung (U.i) und die Redundanz-Messspannung (Ur.i) in Abhängigkeit einer in einem induktiven Sensorelement (5.i) aufgrund der Wechselwirkung mit dem Polrad (4.i) erzeugten Wirkspannung (UW.i) ergeben und
- sich der Messstrom (I.i) und der Redundanz-Messstrom (Ir.i) in Abhängigkeit eines in einem aktiven Sensorelement (3.i) aufgrund der Wechselwirkung mit dem Polrad (4.i) erzeugten Wirkstromes (IW.i) ergeben.

## Claims

1. A method for operating a rotational speed sensor (1a.i ; 1b.i) comprising a sensor element (5.i ; 3.i) in a vehicle (100), in particular a utility vehicle, wherein the sensor element (5.i; 3.i) interacts with a pole wheel (4.i) on a wheel (2.i) of the vehicle (100) and an effective parameter (UW.i; IW.i) generated by the interaction of the pole wheel (4.i) with the sensor element (5.i; 3.i) is evaluated in the form of a measurand (U.i; I.i) in an evaluation module (20) and, depending on the measurand (U.i; I.i), an output variable (UK.i, SK.i) characterizing the rotational speed (D.i) of the wheel (2.i) is output, wherein the sensor element (5.i; 3.i) is supplied via the evaluation module (20) with a sensor voltage (Usens) influencing the measurand (U.i, I.i),
wherein the functionality of the evaluation module (20) is monitored by a redundancy module (21) independent from the evaluation module (20) as to whether the sensor element (5.i; 3.i) is supplied or can be supplied with the sensor voltage (Usens) by the evaluation module (20), wherein in the event of a malfunction of the evaluation module (20), as a consequence thereof the sensor element (5.i; 3.i) is or can no longer be supplied with the sensor voltage (Usens) by the evaluation module (20), a redundancy sensor voltage (Usens_r) is provided by the redundancy module (21), with which the respective sensor element (5.i; 3.i) is supplied instead (St6) to form a redundant voltage supply of the sensor element (5.i; 3.i), wherein in the redundancy module (21) at least the following steps are performed to monitor the functionality of the evaluation module (20) :
- detecting a redundancy measurand (Ur.i; Ir.i) ensuing in the redundancy module (21), wherein the redundancy measurand (Ur.i; Ir.i) arises on the basis of the interaction of the pol wheel (4) with the sensor element (5.i; 3.i), which is supplied with the sensor voltage (Usens) specified by the evaluation module (20); and
- determining whether the redundancy measurand (Ur.i; Ir.i) is an indication that a sensor voltage (Usens) is present which corresponds to a ground potential (M) within a fault tolerance (T),
**characterized in that**,
in the presence of a redundancy measurand (Ur.i; Ir.i) that indicates a sensor voltage (Usens) which corresponds to a ground potential (M) within the fault tolerance (T), a malfunction of the evaluation module is inferred, as a consequence whereof the sensor element (5.i; 3.i) is or can no longer be supplied with the sensor voltage (Usens) by the evaluation module (20),
only when a redundancy measurand (Ur.i; Ir.i), which is assigned to at least one further sensor element (5.i; 3.i) of at least one further rotational speed sensor (1a.i ; 1b.i) of the same sensor arrangement (200) likewise indicates a sensor voltage (Usens), which corresponds to a ground potential (M) within the fault tolerance (T), wherein the at least one further sensor element (5.i; 3.i) is likewise supplied with the sensor voltage (Usens) by the same evaluation module (20) and is likewise monitored for a malfunction by the redundancy module (21) .

2. The method according to claim 1, **characterized in that**, in the event of a malfunction of the evaluation module (20), as a consequence whereof the sensor element (5.i; 3.i) is or can no longer be supplied with the sensor voltage (Usens) by the evaluation module (20), the effective parameter (UW.i; IW.i) generated by the interaction of the pole wheel (4.i) with the sensor element (5.i; 3.i) is evaluated in the form of a redundancy measurand (Ur.i; Ir.i) in the redundancy module (21) and, depending on the redundancy measurand (Ur.i; Ir.i), a redundancy output variable (UKr.i, SKr.i) characterizing the rotational speed (D.i) of the wheel (2.i) is output by the redundancy module (21) to form a redundant evaluation.

3. The method according to claim 1 or 2, **characterized in that**, in the event of a malfunction of the evaluation module (20), as a consequence whereof the sensor element (5.i; 3.i) is or can no longer be supplied with the sensor voltage (Usens) by the evaluation module (20), redundancy supply points (P1r, P2r) of the redundancy module (21) will be connected to the sensor element (5.i; 3.i) in an electrically conducting manner via redundancy lines (26a, 26b) such that the sensor element (5.i; 3.i) is supplied with a redundancy sensor voltage (Usens_r) by the redundancy supply points (P1r, P2r), and the redundancy supply points (P1r, P2r) are otherwise electrically isolated from the sensor element (5.i; 3.i).

4. The method according to claim 3, **characterized in that**, the establishment of the connection of the redundancy supply points (P1r, P2r) to the sensor element (5.i; 3.i) and the separation of the redundancy supply points (P1r, P2r) from the sensor element (5.i; 3.i) occurs via electrical switches (25a, 25b), wherein the electrical switches (25a, 25b) are opened or closed depending on the functionality of the evaluation module (20) .

5. The method according to claim 1, **characterized in that**, the redundancy module (21) monitors a diagnostic signal (SD) output by the evaluation module (20), wherein the diagnostic signal (SD) indicated whether the sensor element (5.i; 3.i) is or can be supplied with the sensor voltage (Usens) via the evaluation module (20).

6. The method according to any of the foregoing claims, **characterized in that**, in the event of a detected standstill of the wheel (2.i) an additional determination is made as to whether the redundancy measurand (Ur.i; Ir.i) corresponds to a mean voltage (UM) and/or a mean current (IM), which ensues when the wheel (2.i) is stationary due to the supply of the sensor element (5.i; 3.i) with the sensor voltage (Usens) without an interaction of the sensor element (5.i; 3.i) with the pole wheel (4.i).

7. The method according to any of the foregoing claims, **characterized in that**, the plausibility of the redundancy measurand (Ur.i; Ir.i) is first verified, wherein to this end a redundancy comparator voltage (Ukr.i) or a redundancy comparator signal (SK.i) is generated from the redundancy measurand (Ur.i; Ir.i) in a redundancy comparator module (27.i) of the redundancy module (21) as an output variable, which respectively indicate whether the redundancy measurand (Ur.i; Ir.i), as a consequence of an interaction of the sensor element (5.i; 3.i) with a pol tooth (4a) of the pole wheel (4.i) deviates by more than a threshold value (U_th; I_th) from the mean voltage (UM) or the mean current (IM), and the redundancy measurand (Ur.i; Ir.i) is compared with the redundancy comparator voltage (UKr.i) or the redundancy comparator signal (SKr.i) to detect inconsistencies in the detected redundancy measurand (Ur.i; Ir.i).

8. The method according to any of the foregoing claims, **characterized in that**,
- as a measurand in the evaluation module (20) a measurement voltage (U.i) and as a redundancy measurand in the redundancy module (21) a redundancy measurement voltage (Ur.i) is processed, wherein the measurement voltage (U.i) and the redundancy measurement voltage (Ur.i) result from the interaction of the pole wheel (4.i) with the sensor element (5.i; 3.i) superimposed with a subsequent mean voltage (UM) from the sensor voltage (Usens) or in the event of a detected malfunction, from the redundancy sensor voltage (Usens_r) or
- as a measurand in the evaluation module (20) a measurement current (I.i) and as a redundancy measurand in the redundancy module (21) a redundancy measurement current (Ir.i) is processed, wherein the measurement current (I.i) and the redundancy measurement current (Ir.i) result from the interaction of the pole wheel (4.i) with the sensor element (5.i; 3.i) superimposed with a subsequent mean current (IM) from the sensor voltage (Usens) or in the event of a detected malfunction, from the redundancy sensor voltage (Usens_r).

9. The method according to claim 8, **characterized in that**
- the measurement voltage (U.i) and the redundancy measurement voltage (Ur.i) result as a function of an effective voltage (UW.i) generated in an inductive sensor element (5.i) on the basis of the interaction with the pole wheel (4.i) and
- the measurement current (I.i) and the redundancy measurement current (Ir.i) result as a function of an effective current (IW.i) generated in an active sensor element (3.i) on the basis of the interaction with the pole wheel (4.i).

## Revendications

1. Procédé pour faire fonctionner un capteur de vitesse de rotation (1a.i ; 1b.i) présentant un élément de capteur (5.i ; 3.i) dans un véhicule (100), en particulier véhicule utilitaire, dans lequel l'élément de capteur (5.i ; 3.i) interagit avec une roue polaire (4.i) sur une roue (2.i) du véhicule (100) et une grandeur effective (UW.i ; IW.i) produite par l'interaction de la roue polaire (4.i) avec l'élément de capteur (5.i ; 3.i) est évaluée sous la forme d'une grandeur de mesure (U.i ; I.i) dans un module d'évaluation (20) et une grandeur de sortie (UK.i, SK.i) caractérisant une vitesse de rotation (D.i) de la roue (2.i) est émise en fonction de la grandeur de mesure (U.i ; I.i), dans lequel l'élément de capteur (5.i ; 3.i) est alimenté avec une tension de capteur (Usens) influençant la grandeur de mesure (U.i ; I.i) par l'intermédiaire du module d'évaluation (20),
dans lequel le bon fonctionnement du module d'évaluation (20) est surveillé par un module de redondance (21) indépendant du module d'évaluation (20), pour voir si l'élément de capteur (5.i ; 3.i) est ou peut être alimenté avec la tension de capteur (Usens) par le module d'évaluation (20), dans lequel dans le cas d'un dysfonctionnement du module d'évaluation (20), à la suite duquel l'élément de capteur (5.i ; 3.i) n'est plus ou ne peut plus être alimenté avec la tension de capteur (Usens) par le module d'évaluation (20), une tension de capteur redondante (Usens_r) est fournie par le module de redondance (21), avec laquelle l'élément de capteur (5.i ; 3.i) respectif est alimenté à la place (St6) pour la réalisation d'une alimentation en tension redondante de l'élément de capteur (5.i ; 3.i), dans lequel dans le module de redondance (21), afin de surveiller le bon fonctionnement du module d'évaluation (20), au moins les étapes suivantes sont mises en œuvre :
- la détection d'une grandeur de mesure redondante (Ur.i ; Ir.i) apparaissant dans le module de redondance (21), dans lequel la grandeur de mesure redondante (Ur.i ; Ir.i) résulte de l'interaction de la roue polaire (4) avec l'élément de capteur (5.i ; 3.i), qui est alimenté avec la tension de capteur (Usens) prédéfinie par le module d'évaluation (20) ; et
- le fait de déterminer si la grandeur de mesure redondante (Ur.i ; Ir.i) indique qu'une tension de capteur (Usens) est présente, qui correspond à un potentiel de masse (M) à l'intérieur d'une tolérance d'erreur (T),
**caractérisé en ce que**
en présence d'une grandeur de mesure redondante (Ur.i ; Ir.i), qui indique une tension de capteur (Usens) qui correspond à un potentiel de masse (M) à l'intérieur de la tolérance d'erreur (T), un dysfonctionnement du module d'évaluation (20) est déduit, à la suite duquel l'élément de capteur (5.i ; 3.i) n'est plus ou ne peut plus être alimenté avec la tension de capteur (Usens) par le module d'évaluation (20),
ce n'est que lorsqu'une grandeur de mesure redondante (Ur.i ; Ir.i), qui est associée au moins à un autre élément de capteur (5.i ; 3.i) au moins d'un autre capteur de vitesse de rotation (1a.i ; 1b.i) du même ensemble de capteurs (200), indique également une tension de capteur (Usens) qui correspond à un potentiel de masse (M) à l'intérieur de la tolérance d'erreur (T), dans lequel le au moins un autre élément de capteur (5.i ; 3.i) est également alimenté avec la tension de capteur (Usens) par le même module d'évaluation (20) et un dysfonctionnement est également surveillé par le module de redondance (21).

2. Procédé selon la revendication 1, **caractérisé en ce que** dans le cas d'un dysfonctionnement du module d'évaluation (20), à la suite duquel l'élément de capteur (5.i ; 3.i) n'est plus ou ne peut plus être alimenté avec la tension de capteur (Usens) par le module d'évaluation (20), la grandeur effective (UW.i ; IW.i) produite par l'interaction de la roue polaire (4.i) avec l'élément de capteur (5.i ; 3.i) est évaluée sous la forme d'une grandeur de mesure redondante (Ur.i ; Ir.i) dans le module de redondance (21), et en fonction de la grandeur de mesure redondante (Ur.i ; Ir.i) une grandeur de sortie redondante (UKr.i, SKr.i) caractérisant la vitesse de rotation (D.i) de la roue (2.i) est émise par le module de redondance (21) pour la réalisation d'une évaluation redondante.

3. Procédé selon la revendication 1 ou 2, **caractérisé en ce que** lors d'un dysfonctionnement du module d'évaluation (20), à la suite duquel l'élément de capteur (5.i ; 3.i) n'est plus ou ne peut plus être alimenté avec la tension de capteur (Usens) par le module d'évaluation (20), des points d'alimentation redondants (P1r, P2r) du module de redondance (21) sont reliés de manière électro-conductrice à l'élément de capteur (5.i ; 3.i) par l'intermédiaire de lignes redondantes (26a, 26b), de telle sorte que l'élément de capteur (5.i ; 3.i) est alimenté avec une tension de capteur redondante (Usens_r) fournie par les points d'alimentation redondants (P1r, P2r), et les points d'alimentation redondants (P1r, P2r) sont sinon séparés électriquement de l'élément de capteur (5.i ; 3.i).

4. Procédé selon la revendication 3, **caractérisé en ce que** la réalisation de la liaison des points d'alimentation redondants (P1r, P2r) à l'élément de capteur (5.i ; 3.i) et la séparation des points d'alimentation redondants (P1r, P2r) de l'élément de capteur (5.i ; 3.i) s'effectue par l'intermédiaire de commutateurs électriques (25a, 25b), dans lequel les commutateurs électriques (25a, 25b) sont ouverts ou fermés en fonction du bon fonctionnement du module d'évaluation (20).

5. Procédé selon la revendication 1, **caractérisé en ce que** le module de redondance (21) surveille un signal de diagnostic (SD) émis par le module d'évaluation (20), dans lequel le signal de diagnostic (SD) indique si l'élément de capteur (5.i ; 3.i) est ou peut être alimenté avec la tension de capteur (Usens) par l'intermédiaire du module d'évaluation (20).

6. Procédé selon l'une quelconque des revendications précédentes, **caractérisé en ce que** lorsqu'une immobilisation de la roue (2.i) est identifiée, il est déterminé en plus si la grandeur de mesure redondante (Ur.i ; Ir.i) correspond à une tension moyenne (UM) et/ou à un courant moyen (IM), qui apparaît à l'immobilisation de la roue (2.i) en raison de l'alimentation de l'élément de capteur (5.i ; 3.i) avec la tension de capteur (Usens) sans interaction de l'élément de capteur (5.i ; 3.i) avec la roue polaire (4.i).

7. Procédé selon l'une quelconque des revendications précédentes, **caractérisé en ce que** la plausibilité de la grandeur de mesure redondante (Ur.i ; Ir.i) après la détection est tout d'abord contrôlée, dans lequel à cet effet une tension de comparateur redondante (Ukr.i) ou un signal de comparateur redondant (SK.i) est produit(e) en tant que grandeur de sortie à partir de la grandeur de mesure redondante (Ur.i ; Ir.i) dans un module de comparateur redondant (27.i) du module de redondance (21), qui indiquent respectivement si la grandeur de mesure redondante (Ur.i ; Ir.i) à la suite d'une interaction de l'élément de capteur (5.i ; 3.i) avec une dent polaire (4a) de la roue polaire (4.i) s'écarte de plus d'une valeur seuil (U_th ; I_th) de la tension moyenne (UM) ou du courant moyen (IM), et la grandeur de mesure redondante (Ur.i ; Ir.i) est comparée à la tension de comparateur redondante (Ukr.i) ou au signal de comparateur redondant (SKr.i) pour la détection d'incohérences dans la grandeur de mesure redondante (Ur.i ; Ir.i) détectée.

8. Procédé selon l'une quelconque des revendications précédentes, **caractérisé en ce que**
- une tension de mesure (U.i) est traitée en tant que grandeur de mesure dans le module d'évaluation (20) et une tension de mesure redondante (Ur.i) en tant que grandeur de mesure redondante dans le module de redondance (21), dans lequel la tension de mesure (U.i) et la tension de mesure redondante (Ur.i) découle de l'interaction de la roue polaire (4.i) avec l'élément de capteur (5.i ; 3.i) combinée à une tension moyenne (UM) découlant de la tension de capteur (Usens) ou lorsqu'un dysfonctionnement est identifié de la tension de capteur redondante (Usens_r) ou
- un courant de mesure (I.i) est traité en tant que grandeur de mesure dans le module d'évaluation (20) et un courant de mesure redondant (Ir.i) en tant que grandeur de mesure redondante dans le module de redondance (21), dans lequel le courant de mesure (I.i) et le courant de mesure redondant (Ir.i) découle de l'interaction de la roue polaire (4.i) avec l'élément de capteur (5.i ; 3.i) combinée à un courant moyen (IM) découlant de la tension de capteur (Usens) ou lorsqu'un dysfonctionnement est identifié de la tension de capteur redondante (Usens_r).

9. Procédé selon la revendication 8, **caractérisé en ce que**
- la tension de mesure (U.i) et la tension de mesure redondante (Ur.i) apparaissent en fonction d'une tension effective (UW.i) produite dans un élément de capteur (5.i) inductif en raison de l'interaction avec la roue polaire (4.i) et
- le courant de mesure (I.i) et le courant de mesure redondant (Ir.i) apparaissent en fonction d'un courant effectif (IW.i) produit dans un élément de capteur (3.i) actif en raison de l'interaction avec la roue polaire (4.i).
